Europäisches Patentamt

European Patent Office

Office européen des brevets

(11) Numéro de publication: **0 387 164**
**A1**

## (12) DEMANDE DE BREVET EUROPEEN

(21) Numéro de dépôt: 90420115.9

(22) Date de dépôt: 02.03.90

(51) Int. Cl.⁵ **G01B 5/14, G01B 5/00**

(30) Priorité: 07.03.89 FR 8903422

(43) Date de publication de la demande:
12.09.90 Bulletin 90/37

(84) Etats contractants désignés:
DE FR GB IT NL

(71) Demandeur: **ETAT FRANCAIS représenté par
le Ministre des PTT (Centre National
d'Etudes des Télécommunications)**
**38-40 rue du Général Leclerc**
**F-92131 Issy-les-Moulineaux(FR)**

(72) Inventeur: **Doeuvre, Jean-Pierre**
**16, Le Routoir**
**Les Grubbins, F-38240 Meylan(FR)**
Inventeur: **Mascarin, Guy**
**19, Avenue du Vercors**
**F-38240 Meylan(FR)**

(74) Mandataire: **de Beaumont, Michel**
**1bis, rue Champollion**
**F-38000 Grenoble(FR)**

(54) Appareil automatique de contrôle dimensionnel de nacelles porte-plaquettes.

(57) La présente invention concerne un appareil de contrôle dimensionnel d'une nacelle porte-plaquettes telle que les plaquettes maintenues par la nacelle doivent se trouver à des distances prédéterminées d'au moins deux faces extrêmes particulières de cette nacelle. Cet appareil comprend un plan incliné (31), deux surfaces de référence (32), des moyens de guidage (34) agencés pour que, quand la nacelle est posée sur le plan incliné, elle puisse y glisser de façon que les faces extrêmes viennent buter contre les surfaces de référence, au moins une plaque (50) munie d'une portion de rainure de référence (51) disposée pour prolonger dans leur plan les rainures de maintien d'une plaquette à une position déterminée. Ainsi, quand les faces extrêmes sont en butée contre les surfaces de référence, une plaquette ne peut être insérée dans ses rainures de maintien et dans la rainure de référence que si les dimensions de la nacelle correspondent à une norme déterminée.

Fig. 2

# APPAREIL AUTOMATIQUE DE CONTROLE DIMENSIONNEL DE NACELLES PORTE-PLAQUETTES

La présente invention concerne le domaine de la fabrication des circuits intégrés où de très nombreuses étapes sont réalisées tandis que des plaquettes sont groupées par lots sur des nacelles porte-plaquettes.

Ces nacelles doivent pouvoir être introduites dans des appareils de traitement (des fours, des réacteurs, etc.) et s'adapter à des appareils automatiques de transfert de plaquettes d'une nacelle à l'autre.

Il importe donc que les cotes des nacelles soient précises pour que, d'une part, les plaquettes soit convenablement positionnées dans un appareil de traitement où elles doivent être insérées, d'autre part, un appareil de transfert ne brise pas les plaquettes quand il vient les saisir ou les déposer.

Pour la vérification de ces cotes, les fabricants de nacelles se contentent jusqu'à présent d'effectuer leurs opérations de fabrication aussi soigneusement que possible et de mesurer manuellement, individuellement et indépendamment diverses cotes des nacelles fabriquées.

La présente invention a pour objet de prévoir un appareil automatique de contrôle dimensionnel de nacelles porte-plaquettes.

Pour atteindre cet objet, la présente invention prévoit un appareil de contrôle dimensionnel d'une nacelle porte-plaquettes telle que les plaquettes maintenues par la nacelle doivent se trouver à des distances prédéterminées d'au moins deux faces extrêmes particulières de cette nacelle, comprenant :
- une surface inclinée
- deux surfaces de référence,
- des moyens de guidage agencés pour que, quand la nacelle est posée sur le plan incliné, elle puisse y glisser de façon que lesdites faces extrêmes viennent normalement buter contre lesdites surfaces de référence,
- au moins une plaque munie d'au moins une portion de rainure de référence disposée pour prolonger dans leur plan les rainures de maintien d'une plaquette à une position déterminée.

Ainsi, quand les faces extrêmes sont en butée contre les surfaces de référence, une plaquette ne peut être insérée dans ses rainures de maintien et dans la rainure de référence que si les dimensions de la nacelle correspondent à une norme déterminée par les distances relatives entre les surfaces de référence et la rainure de référence.

De préférence, l'appareil selon la présente invention comprend des moyens de détection de l'appui des faces extrêmes contre les surfaces de référence et de détection de l'insertion d'une plaquette dans la rainure de référence.

Les moyens de détection d'appui peuvent être constitués de contacts à boutons-poussoirs affleurant de la surface de référence au niveau où doivent venir s'appuyer les faces extrêmes.

Les moyens de détection d'insertion sont constitués de l'ensemble d'un photodétecteur et d'un photorécepteur disposés de part et d'autre de la rainure de référence.

De préférence, l'appareil selon la présente invention est réalisé sous forme d'un appareil portable et autonome comprenant notamment des moyens d'alimentation électrique.

L'un des avantages d'un tel appareil est que sa conception est extrêmement simple et qu'il peut être fabriqué à faible coût sous forme d'un appareil portatif léger et peu encombrant. Ainsi, cet appareil peut être utilisé ou bien par le fabricant de nacelles ou bien par le fabricant de circuits intégrés qui voudra tester des nacelles avant de les utiliser et évitera ainsi de perdre des lots de fabrication complets.

Ces objets, caractéristiques et avantages ainsi que d'autres de la présente invention apparaîtront de façon plus détaillée dans la description suivante de modes de réalisation particuliers faite en relation avec les figures jointes parmi lesquelles :

la figure 1 est une vue en perspective d'une nacelle à laquelle s'applique la présente invention ,

la figure 2 est une vue simplifiée de côté et en coupe selon la ligne A-A de la figure 3 d'un appareil selon la présente invention ;

la figure 3 est une vue de dessus d'un appareil selon la présente invention ;

la figure 4 est une vue selon la flèche B de la figure 2 d'un appareil selon la présente invention ; et

la figure 5 est une vue en coupe selon les lignes C-C de la figure 2 d'un appareil selon la présente invention.

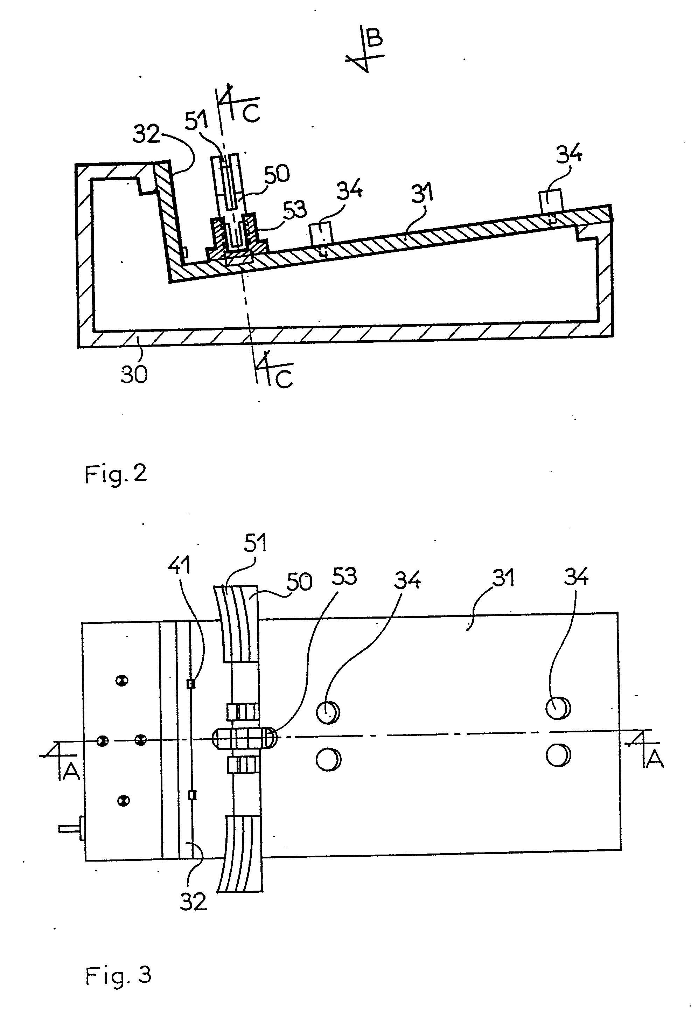

La figure 1 représente un exemple typique de nacelle porte-plaquettes telle qu'utilisée dans l'industrie de la fabrication des circuits intégrés. Cette nacelle en quartz, comprend quatre tiges parallèles 1, 2, 3 et 4. Ces tiges sont maintenues les unes par rapport aux autres par fixation à deux supports en U 5 et 6 dont les parties supérieures comprennent des anses de préhension 7 et 8.

Des rainures correspondantes 11, 12, 13, 14 sont ménagées dans les tiges 1, 2, 3 et 4 selon des plans parallèles successifs perpendiculaires à la direction des tiges, de façon à maintenir les plaquettes 15 en position verticale. On notera d'ailleurs que l'on pourrait prévoir les plans de ces rainures pour que les plaquettes soient maintenues avec un certain angle par rapport à la verticale.

Les plans des rainures, c'est-à-dire les positions auxquelles doivent être maintenues les plaquettes 15 à l'intérieur de la nacelle doivent être définis avec précision par rapport à une référence liée au corps de la nacelle, par exemple par rapport aux faces extrêmes 21 et 22, d'une part, 23 et 24, d'autre part, des tiges 2 et 3.

Ce positionnement doit être précis dans plusieurs cas d'utilisation, par exemple pour le transfert automatique des plaquettes d'une nacelle à une autre. Dans ce cas, un appareil de préhension vient saisir une, plusieurs ou l'ensemble des plaquettes contenues dans une nacelle pour les insérer dans une ou plusieurs autres nacelles. Si la position relative des diverses rainures des diverses nacelles n'est pas exactement connue l'appareil de transfert positionnera mal les plaquettes dans la ou les nacelles réceptrices et il pourra se produire des bris ou des chutes de plaquettes.

Ainsi, l'invention prévoit un appareil de vérification de cotes d'une nacelle qui est représenté en figures 2 à 5 dans le cas particulier où la nacelle à tester est telle que représentée en figure 1. On se référera de façon globale à l'ensemble de ces figures 2 à 5 où de mêmes éléments sont désignés par de mêmes références numériques.

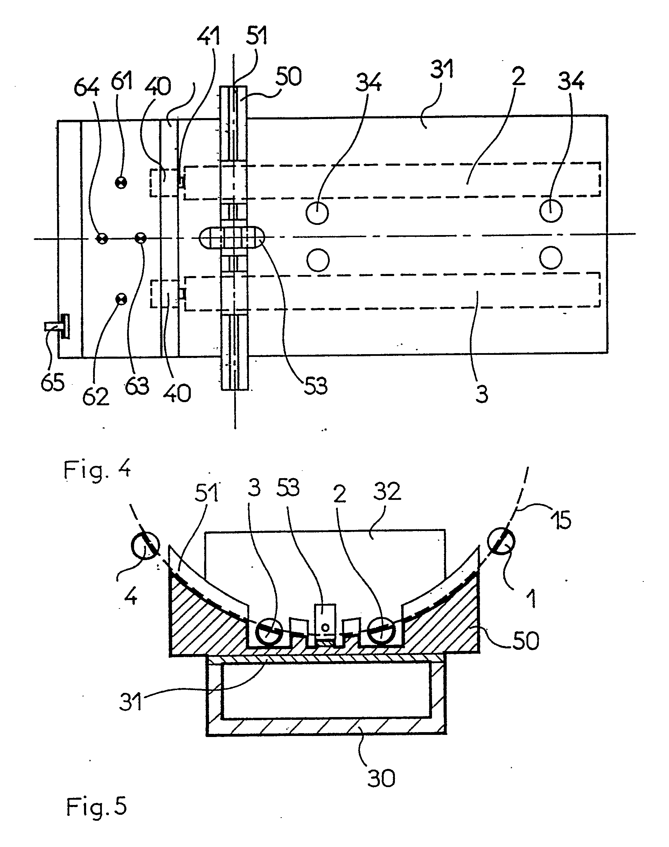

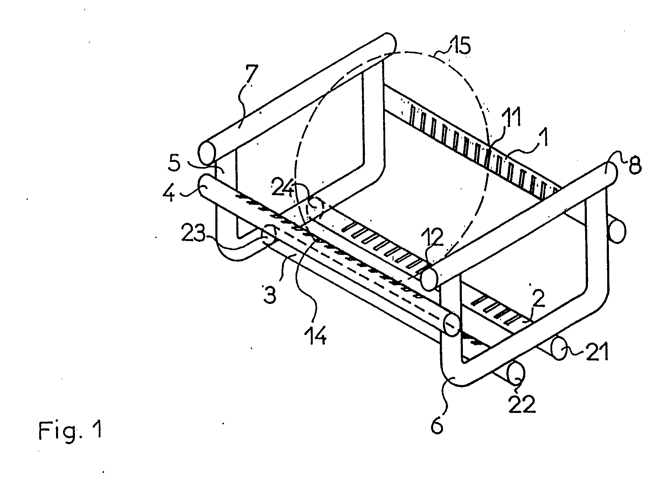

L'appareil comprend un boîtier 30 sur lequel est montée une plaque en forme de L comprenant un plan incliné 31 et une surface d'appui 32. Des plots 34, en saillie par rapport au plan incliné 31 sont destinés à assurer le guidage des tiges inférieures 2 et 3 de la nacelle. Ces tiges inférieures sont représentées schématiquement en figures 4 et 5.

Des détecteurs à boutons-poussoirs 40 laissent passer leur extrémité de contact 41 à travers la plaque d'appui 32, à l'emplacement où doivent venir s'appuyer les plans d'extrémité (plans de référence) des tiges 2 et 3. La plage de sensibilité de ces détecteurs peut être couramment de l'ordre du dixième de millimètre. On peut ainsi détecter si les tiges 2 et 3, positionnées par les plots 34 viennent convenablement en butée contre les contacts 41. La nacelle étant convenablement positionnée, il reste à déterminer si les plans des rainures sont à des distances convenables (à l'intérieur d'une tolérance prédéterminée) des plans de référence susmentionnés. En fait, on effectuera cette détermination pour un seul des plans de rainures car, en pratique, la distance entre plans de rainures peut être obtenue avec une grande précision en utilisant une scie à roues multiples pour former simultanément toutes les rainures.

Ainsi, pour déterminer l'exactitude de la cote entre les plans de référence susmentionnés et le plan d'un ensemble de rainures de maintien d'une plaquette, la présente invention prévoit de disposer une plaque 50 de la façon illustrée. Cette plaque est munie d'ouvertures adaptées à la nacelle particulière à tester pour permettre le placement et le glissement de cette nacelle contre le plan d'appui 32 comme cela a été décrit précédemment. La plaque 50 est découpée et munie d'une rainure 51 qui, quand une nacelle est convenablement positionnée, vient compléter les rainures d'un plan de rainures des tiges 1, 2, 3 et 4, de sorte que, comme le représente la figure 5, une plaquette vient s'insérer simultanément dans les rainures 11, 12, 13 et 14 de la nacelle et dans la ou les portions de rainures 51 de la plaque 50. Si le positionnement du plan considéré de rainures des tiges de la nacelle par rapport aux surfaces de référence de cette nacelle n'est pas conforme à des normes prédéterminées, la plaquette ne pourra pas être insérée car elle butera contre les parties en relief ou bien des tiges 1 à 4 ou bien de la plaque 50.

En outre, la présente invention prévoit un détecteur 53 pour indiquer le positionnement convenable d'une plaquette dans les rainures de la nacelle et de la plaque 50. Ce détecteur est par exemple du type opto-électronique et comprend par exemple une diode photoémettrice et une diode ou un transistor photorécepteur placés en vis-à-vis.

Pour résumer, l'appareil selon l'invention comprend une structure mécanique spécifique et trois détecteurs, deux pour déterminer le positionnement convenable de la nacelle et un pour déterminer l'insertion d'une plaquette. A partir du moment où l'on dispose de tels détecteurs, tout technicien du domaine de l'électronique, des circuits logiques et des affichages pourra fournir à la suite de cette détection une indication appropriée. Par exemple, on pourra prévoir un voyant (61-63) associé à chacun des détecteurs s'allumant quand celui-ci est convenablement actionné (c'est-à-dire que les boutons-poussoirs 41 sont pressés et qu'une plaquette vient interrompre le trajet entre la diode photoémettrice et la diode photoréceptrice). Un voyant supplémentaire pourra être associé à la détection d'un défaut, c'est-à-dire au non-allumage de l'un des voyants précédents. On pourra en outre prévoir une commande de test 65 pour vérifier le bon fonctionnement des voyants.

Bien entendu, la présente invention est susceptible de nombreuses variantes et modifications qui apparaîtront à l'homme de l'art. L'appareil de contrôle selon l'invention a été décrit dans le cadre d'une nacelle particulière et d'un positionnement particulier de ses plans de référence. Il est clair qu'une telle nacelle pourrait comprendre plus de deux plans de référence, que ces plans de référence ne sont pas nécessairement au même niveau sont éventuellement décalés l'un par rapport à l'autre, ou sont dans des plans obliques l'un par rapport à l'autre. Dans ce dernier cas, la surface d'appui au lieu d'être une surface unique sera constituée d'un dièdre.

De même, alors que l'on a mentionné un plan incliné sur lequel est posée la nacelle à tester, on pourrait aussi prévoir une surface de glissement horizontale sur laquelle est poussée la nacelle.

En outre, on notera qu'un appareil selon la présente invention se prête facilement à une réalisation sous forme d'un appareil autonome, le boîtier 30 contenant par exemple des piles et tous les circuits logiques nécessaires.

## Revendications

1. Appareil de contrôle dimensionnel d'une nacelle porte-plaquettes telle que les plaquettes maintenues par la nacelle doivent se trouver à des distances prédéterminées d'au moins deux faces extrêmes particulières de cette nacelle, caractérisé en ce qu'il comprend :
- une surface de glissement (31),
- deux surfaces de référence (32),
- des moyens de guidage (34) agencés pour que, quand la nacelle est posée sur la surface de glissement, elle puisse y glisser de façon que lesdites faces extrêmes viennent normalement buter contre lesdites surfaces de référence,
- au moins une plaque (50) munie d'au moins une portion de rainure de référence (51) disposée pour prolonger dans leur plan les rainures de maintien d'une plaquette à une position déterminée,
d'où il résulte que, quand les faces extrêmes sont en butée contre les surfaces de référence, une plaquette ne peut être insérée dans ses rainures de maintien et dans la rainure de référence que si les dimensions de la nacelle correspondent à une norme déterminée par les distances relatives entre les surfaces de référence et la rainure de référence.

2. Appareil de contrôle dimensionnel selon la revendication 1, caractérisé en ce qu'il comprend des moyens (40, 41) de détection de l'appui des faces extrêmes contre les surfaces de référence et des moyens (53) de détection de l'insertion d'une plaquette dans la rainure de référence.

3. Appareil selon la revendication 2, caractérisé en ce que les moyens de détection d'appui sont constitués de contacts à boutons-poussoirs affleurant de la surface de référence au niveau où doivent venir s'appuyer les faces extrêmes.

4. Appareil selon la revendication 2, caractérisé en ce que les moyens de détection d'insertion sont constitués de l'ensemble d'un photodétecteur et d'un photorécepteur disposés de part et d'autre de la rainure de référence.

5. Appareil selon les revendications 2, 3 et 4, caractérisé en ce qu'un voyant (61 - 63) est associé à chacun des détecteurs.

6. Appareil selon la revendication 5, caractérisé en ce qu'il comprend un voyant supplémentaire (64) fonctionnant de façon complémentaire aux trois autres.

7. Appareil selon l'une quelconque des revendications 1 à 6, caractérisé en ce qu'il est réalisé sous forme d'un appareil portable et autonome comprenant notamment des moyens d'alimentation électrique.

8. Appareil selon la revendication 1, dans lequel la nacelle comprend quatre tiges parallèles munies de rainures d'insertion de plaquettes disposées dans des plans successifs perpendiculaires à ces tiges, les extrémités de deux des tiges correspondant auxdites faces extrêmes, caractérisé en ce que les moyens de guidage sont des bossages (34) prévus sur le plan incliné permettant le coulissement sur la surface de glissement desdites tiges parallèlement à leur axe.

Fig. 2

Fig. 3

Fig. 4

Fig. 5

Fig. 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | CH-A- 400 582 (VEB MIKROMAT DRESDEN) <br> * page 1; page 2, lignes 1-54 * <br> --- | 1 | G 01 B 5/14 <br> G 01 B 5/00 |
| A | GB-A-1 392 816 (THE PLESSEY CO. LTD.) <br> * page 2 * <br> --- | 1 | |
| A | PATENT ABSTRACTS OF JAPAN <br> vol. 11, no. 142 (P-573)(2589), 9 mai <br> 1987; & JP - A - 61 278 768 (MEIKO <br> DENSHI KOGYO K.K.) 09.12.1986 <br> --- | 1 | |
| A,P | WO-A-8 902 571 (ISES) <br> * revendications 1-21 * <br> ----- | 1 | |

**DOMAINES TECHNIQUES RECHERCHES (Int. Cl.5)**

G 01 B 5/00
G 01 B 7/00
G 01 B 11/00
G 01 B 21/00

Le présent rapport a été établi pour toutes les revendications

| Lieu de la recherche | Date d'achèvement de la recherche | Examinateur |
|---|---|---|
| BERLIN | 13-06-1990 | DIETRICH A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

....................................................................

& : membre de la même famille, document correspondant

EPO FORM 1503 03.82 (P0402)